# EUROPÄISCHE PATENTSCHRIFT

(11) **EP 3 368 408 B1**
(45) Veröffentlichungstag und Bekanntmachung des Hinweises auf die Patenterteilung: **15.05.2024**
(21) Anmeldenummer: 16782194.1
(22) Anmeldetag: 27.09.2016
(51) Int. Cl.: B63C 11/26, H04B 11/00

(54) **TONWIEDERGABEEINRICHTUNG UND VERFAHREN ZUR ANPASSUNG EINER TONWIEDERGABEEINRICHTUNG**
SOUND REPRODUCTION DEVICE AND METHOD FOR ADAPTING A SOUND REPRODUCTION DEVICE
DISPOSITIF DE REPRODUCTION SONORE ET PROCÉDÉ D'ADAPTATION D'UN DISPOSITIF DE REPRODUCTION SONORE

(30) Priorität: 30.10.2015 DE 102015118588
(43) Veröffentlichungstag der Anmeldung: 05.09.2018
(73) Patentinhaber: Peiker acustic GmbH & Co. KG, 61381 Friedrichsdorf (DE)
(72) Erfinder: KLOSE, Michael, 61381 Friedrichsdorf (DE)
(74) Vertreter: Otten, Roth, Dobler & Partner mbB Patentanwälte
(86) Internationale Anmeldenummer: PCT/EP2016/072908
(87) Internationale Veröffentlichungsnummer: WO 2017/071899

(56) Entgegenhaltungen:
- WO-A1-2013/183147
- DE-A1- 4 423 362
- DE-A1- 19 513 066
- US-A1- 2013 329 898
- US-A1- 2015 155 839

## Beschreibung

Die Erfindung betrifft eine Tonwiedergabeeinrichtung, ein Verfahren zur Anpassung einer Tonwiedergabeeinrichtung, eine Taucherbrille sowie ein Kommunikationsgerät gemäß dem Oberbegriff des Anspruchs 1 bzw. 5 bzw. 10 bzw. 13.

Aus der DD 158 019 A1 ist eine Hör/Sprech-Garnitur für leichte Taucher bekannt. Hierbei besteht die Garnitur aus einer Hörkapsel und einem Körperschallmikrofon, die in einem elastischen, wasserdichten und zweckmäßig gestalteten Formstück so integriert sind, dass die Hörkapsel direkt vor dem Ohr und das Körperschallmikrofon am Hals neben dem Kehlkopf lokalisiert werden. Nachteilig an einer derartigen Garnitur ist, dass die Hörkapsel direkt vor dem Ohr wasserdicht positioniert werden muss.

Weiterhin ist aus der JPH0368226 A eine mit Ultraschall arbeitende Unterwasserkommunikationsausrüstung bekannt.

In der DE 44 23 362 A1 ist eine Vorrichtung zur Überprüfung der Kopfhörer einer Kopfhöreranordnung bekannt.

Die WO 2013/183147 A1 offenbart eine Unterwassertelefoneinrichtung.

Die DE 195 13 066 A1 beschreibt eine Schaltungsanordnung zum Prüfen des Anschlusses einer Tonwiedergabevorrichtung an eine Tonsignalquelle.

Aus der US 2013/329898 A1 ist ein Wärmesteuermodul bekannt. Dieses berechnet eine Schätzung einer Temperatur eines Lautsprechers basierend auf einem Audiosignal, das den Lautsprecher antreibt, und berechnet eine Verstärkung, die angewendet wird, um das Audiosignal zu dämpfen, um eine Überhitzung des Lautsprechers zu verhindern. Das thermische Steuermodul berechnet eine angepasste Impedanz, die eine Schätzung der Impedanz des Lautsprechers einschließlich seines Gleichstromwiderstands ist, und verwendet sie, um die Temperaturschätzung zu berechnen. Die angepasste Impedanz wird aus einem normalen Anpassungsprozess erhalten, wenn eine gemessene Spannung des Lautsprechers über einem Schwellenwert liegt, und einem Abklingprozess, wenn die gemessene Spannung unter dem Schwellenwert liegt.

Aus der US 2015/155839 A1 ein Mehrkanal-Audioverstärker, bei welchem die Überlagerung von Kanal zu Kanal wesentlich reduziert ist, indem in jedem Kanal ein lokaler Dreiecksrampengenerator verwendet wird, der durch ein einziges globales digitales Taktsignal gesteuert wird. Der rauschkritische Zeit-/Integrationskondensator für den Dreiecksrampengenerator befindet sich lokal in jedem Kanal und neben dem PWM-Komparator dieses Kanals und ist auf die lokale Masse dieses Kanals bezogen. Hierbei kann der Verstärker auch eine Schaltung zur Begrenzung des Arbeitszyklus enthalten, um die Verfügbarkeit der Ausgangsleistung in Abhängigkeit von der Impedanz aller angeschlossenen Lasten (Lautsprecher) zu begrenzen.

Schließlich offenbart die DE 10 2009 041 999 A1 ein Headset bzw. einen Kopfhörer, welcher einer verbesserte Einschaltverzögerung aufweist.

Es ist Aufgabe der Erfindung, eine Tonwiedergabeeinrichtung bzw. ein Verfahren zur Anpassung einer Tonwiedergabeeinrichtung vorzuschlagen, mit der bzw. mit dem ein Lautsprecher auf einfache Weise derart in verschiedenen Medien betrieben werden kann, dass trotz eines Medienwechsels ein gleichbleibendes Hörerlebnis sichergestellt ist, obwohl dieser nicht direkt vor dem Ohr und nicht wasserdicht abgeschlossen betrieben wird.

Diese Aufgabe wird ausgehend von den Merkmalen des Oberbegriffs des Anspruchs 1 bzw. 5 durch die kennzeichnenden Merkmale des Anspruchs 1 bzw. 5 gelöst. In den jeweiligen Unteransprüchen sind vorteilhafte und zweckmäßige Weiterbildungen angegeben.

Bei einer Tonwiedergabeeinrichtung, welche eine Signalquelle, eine Energiequelle, einen Verstärker und einen Lautsprecher umfasst, ist es vorgesehen, dass die Tonwiedergabeeinrichtung weiterhin eine Impedanzmesseinrichtung und eine Auswerteinrichtung umfasst, wobei die Impedanzmesseinrichtung zur Messung von Impedanzwerten an Lautsprecherleitungen des Lautsprechers angeschlossen ist, wobei die Impedanzmesseinrichtung zur Weiterleitung von Messergebnissen an die Auswerteinrichtung angeschlossen ist und wobei die Auswerteinrichtung zur Anpassung eines dem Lautsprecher zugeführten Signals an die Signalquelle und/oder an den Verstärker angeschlossen ist. Anhand der von der Impedanzmesseinrichtung gemessenen Impedanzwerte kann mittels der Auswerteinrichtung jederzeit anhand einer charakteristischen Veränderung der Impedanzwerte festgestellt werden, ob der Lautsprecher der Tonwiedergabeeinrichtung im Medium Luft oder im Medium Wasser betrieben wird und kann der Lautsprecher dann mit auf das jeweilige Medium angepassten Signalen beschickt werden. Hierdurch ist es möglich, für einen Nutzer unabhängig vom Medium, in welchem sich dieser befindet, ein gleichbleibendes Hörerlebnis sicherzustellen. Somit muss der Nutzer beim Wechsel von einem Medium in das andere auch keine manuelle Justierung von Audioeinstellungen vornehmen.

Weiterhin ist es bei der Tonwiedergabeeinrichtung vorgesehen, eine Membran des Lautsprechers der Tonwiedergabeeinrichtung unter Wasser beidseitig an das Medium Wasser angrenzen zu lassen und über Wasser beidseitig an das Medium Luft angrenzen zu lassen. Hierdurch wird vermieden, dass bei der Wahl der Audioeinstellungen Grenzschichten berücksichtigt werden müssen, so dass die Wahl geeigneter Audioeigenschaften vereinfacht ist.

Erfindungsgemäße ist es vorgesehen:
- mit der Auswerteinrichtung aus dem Messergebnis das Medium, in welchem sich der Lautsprecher befindet, zu ermitteln und
- die Signalquelle und/oder den Verstärker von der Auswerteinrichtung derart anzusteuern, dass Paramater wie Wiedergabelautstärke und/oder Frequenzgang derart an das detektierte Medium angepasst werden, dass für einen Nutzer unabhängig vom Medium, in welchem der Lautsprecher betrieben wird, ein gleichbleibendes Hörerlebnis sichergestellt wird.

Anhand der von der Impedanzmesseinrichtung gemessenen Impedanzwerte kann mittels der Auswerteinrichtung jederzeit anhand einer charakteristischen Veränderung der Impedanzwerte festgestellt werden, ob der Lautsprecher der Tonwiedergabeeinrichtung im Medium Luft oder im Medium Wasser bestrieben wird und kann der Lautsprecher dann mit auf das jeweilige Medium angepassten Signalen beschickt werden. Hierdurch ist es möglich, für einen Nutzer, unabhängig vom Medium, in welchem sich dieser befindet, ein gleichbleibendes Hörerlebnis sicherzustellen. Somit muss der Nutzer beim Wechsel von einem Medium in das andere auch keine manuelle Justierung von Audioeinstellungen vornehmen.

Es ist auch vorgesehen, die Tonwiedergabeeinrichtung mit einem Vorwiderstand auszustatten, wobei der Vorwiederstand bei der Messung von Impedanzwerten mit der Impedanzmesseinrichtung dem Lautsprecher vorgeschaltet ist. Hierdurch lassen sich Impedanzwerte auf dem Wege einer Relativmessung genau messen.

Weiterhin ist es vorgesehen, die Tonwiedergabeeinrichtung mit einem Tongenerator auszustatten, wobei durch den Tongenerator Tonsignale erzeugbar und an den Lautsprecher übermittelbar sind. Anhand dieses Tonsignals ist es möglich, mit der Impedanzmesseinrichtung gezielte Messungen vorzunehmen. Sofern in der Auswerteinrichtung zu diesen Messungen Referenzwerte gespeichert sind, lässt sich das jeweilige Medium auf diese Weise besonders schnell und zuverlässig bestimmen.

Weiterhin ist es vorgesehen, den Tongenerator von der Auswerteinrichtung oder der Impedanzmesseinrichtung zu steuern bzw. regeln. Somit können Tonsignale bei Bedarf von den Komponenten aktiviert werden, welche die Kontrolle über die Signalquelle und/oder den Verstärker ausüben.

Es ist vorgesehen, mit der Impedanzmesseinrichtung kontinuierlich Impedanzwerte zu messen oder mit der Impedanzmesseinrichtung in Intervallen Impedanzwerte zu messen oder mit der Impedanzmesseinrichtung Impedanzwerte ereignisgesteuert zu messen. Ein kontinuierliches Messen bringt den Vorteil mit sich, dass eine Umstellung der Audioeinstellungen mit minimaler Verzögerung erfolgen kann. So können diese beispielsweise bei einem Sprung ins Wasser quasi mit dem Eintauchen ins Wasser umgestellt werden. Eine Messung in Intervallen hat den Vorteil, dass die Tonwiedergabeeinrichtung hierdurch energiesparend betrieben werden kann, da die Auswerteinrichtung nicht dauernd arbeiten muss. Eine ereignisgesteuerte Messung hat schließlich die Vorteile, dass ein energiesparender Betrieb möglich ist, da die Auswerteinrichtung nicht dauernd arbeiten muss, und dass weiterhin die Audioeinstellungen mit minimaler Verzögerung angepasst werden können. Für die Ereignissteuerung ist es vorgesehen, dass die Tonwiedergabe eine Sensoreinrichtung umfasst, wobei die Sensoreinrichtung insbesondere einen Drucksensor und/oder einen Beschleunigungssensor und/oder einen Helligkeitssensor und/oder eine Feuchtigkeitssensor und/oder einen GPS-Sensor umfasst. So ist beispielsweise wenn der Beschleunigungssensor eine starke Beschleunigung registriert und der GPS-Sensor eine Position im Bereich eines Gewässers feststellt auf Grund der Vermutung, dass ein Sprung ins Wasser erfolgt, eine Aktivierung der Impedanzmesseinrichtung und der Auswerteinrichtung vorgesehen.

Es ist auch vorgesehen, die Messung von Impedanzwerten durch die Impedanzmesseinrichtung im Bereich einer Resonanz des Lautsprechers vorzunehmen. Hierdurch lassen sich aussagekräftige Impedanzmesswerte erzielen.

Weiterhin ist es vorgesehen, mit einem Tongenerator der Tonwiedergabeeinrichtung ein Testsignal zu erzeugen und dieses an den Lautsprecher zu übermitteln, wobei gleichzeitig eine Messung von Impedanzwerten mit der Impedanzmesseinrichtung durchgeführt wird. Hierdurch lassen sich zu beliebigen Zeitpunkten unabhängig von einer Nutzung der Tonwiedergabeeinrichtung aussagekräftige Impedanzmesswerte ermitteln.

Es ist insbesondere vorgesehen, das Testsignal insbesondere kurzzeitig in einer Kommunikationspause zu erzeugen. Hierdurch wird eine Beeinträchtigung der Kommunikation durch das Testsignal vermieden.

Weiterhin ist es vorgesehen, das Testsignal in einem vom Nutzer nicht wahrnehmbaren Frequenzbereich zu erzeugen. Hierdurch wird eine Ablenkung des Nutzers durch das Testsignal vollständig vermieden.

Weiterhin ist eine Taucherbrille vorgesehen, welche eine Tonwiedergabeeinrichtung umfasst, welche entsprechend wenigstens einem der Ansprüche 1 bis 4 ausgebildet ist, und weist somit die jeweils oben genannten Vorteile auf.

Bei der Taucherbrille ist es weiterhin vorgesehen, den Lautsprecher der Tonwiedergabeeinrichtung an einer Maske der Taucherbrille anzuordnen oder den Lautsprecher der Tonwiedergabeeinrichtung an einer Brillenschlaufe der Taucherbrille anzuordnen.

Weiterhin ist es vorgesehen, dass die Taucherbrille auch eine Tonaufnahmeeinrichtung umfasst, wobei die Tonaufnahmeeinrichtung wenigstens ein Mikrofon umfasst, welches insbesondere als Körperschallmikrofon ausgebildet ist. Hierdurch ist die Taucherbrille für eine bidirektionale Kommunikation geeignet.

Schließlich ist es vorgesehen, die Taucherbrille mit einer Sende- und Empfangseinrichtung auszustatten, wobei die Tonwiedergabeeinrichtung und die Tonaufnahmeeinrichtung an die Sende- und Empfangseinrichtung angeschlossen sind. Hierdurch kann die Taucherbrille als Teilnehmerin in ein drahtgebundenes oder drahtloses Kommunikationsnetzwerk eingebunden werden.

Im Sinne der Erfindung wird unter dem Begriff "Impedanz" der im Betrieb eines Lautsprechers oder eines Mikrofons messbare Widerstand verstanden, welcher insbesondere durch die Summe der elektrischen sowie mechanischen Widerstände hervorgerufen wird.

Die akustische Signal Wiedergabe mittels eines Lautsprechers eines akustischen Kommunikationsgerätes, welches sowohl an der Luft als auch unter Wasser betrieben wird, ändert sich signifikant zwischen Luft-Betrieb und Unterwasser-Betrieb. Der Nutzer muss bei einem Wechsel zwischen den beiden Medien manuell die Wiedergabelautstärke und/oder den Frequenzgang auf das jeweilige Medium anpassen, um ein gleiches Hörerlebnis zu erreichen. Das erfindungsgemäße Verfahren ermöglicht eine automatische Anpassung von Wiedergabelautstärke und/oder Frequenzgang durch eine Detektion des umgebenden Mediums direkt über eine Messung der Impedanz des Lautsprechers und eine entsprechend angepasste Ansteuerung des Verstärkers und/oder eine Anpassung des dem Verstärker zugeführten Signals. Für eine Messung wird die Impedanz des Lautsprechers insbesondere im Bereich seiner Resonanz gemessen, da sich diese in diesem Bereich zwischen dem Betrieb an Luft oder unter Wasser signifikant ändert. Bei dem erfindungsgemäßen Verfahren wird die Impedanz des Lautsprechers mittels einer Auswerteeinheit hinter dem Verstärker oder einer in dem Verstärker integrierten Auswerteeinheit ermittelt und ausgewertet. Bei entsprechender Änderung der festgestellten bzw. gemessenen Impedanz werden die Parameter Wiedergabelautstärke und/oder Frequenzgang in der Signalquelle und/oder in dem Verstärker an das jeweilige Medium angepasst.

Weitere Einzelheiten der Erfindung werden in der Zeichnung anhand von schematisch dargestellten Ausführungsbeispielen beschrieben.

Hierbei zeigt:
- Figur 1:: einen schematischen Schaltplan einer ersten Ausführungsvariante einer erfindungsgemäßen Tonwiedergabeeinrichtung;
- Figur 2:: einen schematischen Schaltplan einer zweiten Ausführungsvariante einer erfindungsgemäßen Tonwiedergabeeinrichtung und
- Figur 3:: eine Taucherbrille.

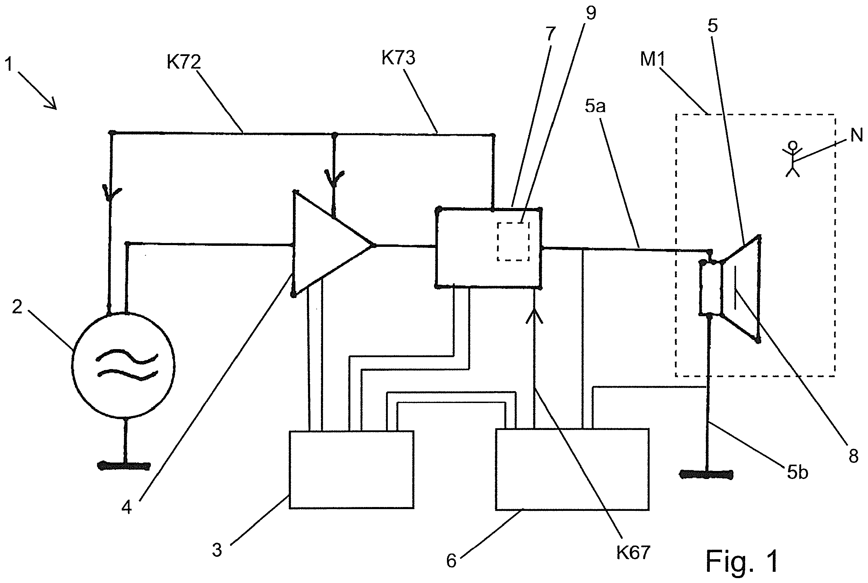

In der Figur 1 ist ein schematischer Schaltplan einer ersten Ausführungsvariante einer erfindungsgemäßen Tonwiedergabeeinrichtung 1 gezeigt. Die Tonwiedergabeeinrichtung 1 umfasst eine Signalquelle 2, eine Energiequelle 3, einen Verstärker 4 und einen Lautsprecher 5. Weiterhin umfasst die Tonwiedergabeeinrichtung 1 eine Impedanzmesseinrichtung 6 und eine Auswerteinrichtung 7. Hierbei ist die Impedanzmesseinrichtung 6 zur Messung von Impedanzwerten an Lautsprecherleitungen 5a, 5b des Lautsprechers 5 angeschlossen. Die Impedanzmesseinrichtung 6 ist zur Weiterleitung von Messergebnissen mit der Auswerteinrichtung 7 verbunden. Die Auswerteinrichtung 7 ist zur Anpassung eines dem Lautsprecher 5 zugeführten Signals an die Signalquelle 2 und an den Verstärker 4 angeschlossen. Gemäß einer nicht dargestellten Ausführungsvariante ist es auch vorgesehen, die Auswerteinrichtung 7 nur an die Signalquelle 2 oder nur an den Verstärker 4 anzuschließen. Die Energiequelle 3 versorgt den Verstärker 4, die Auswerteinrichtung 7 und die Impedanzmesseinrichtung 6 mit elektrischer Energie. Der Lautsprecher 5 befindet sich in einem ersten Medium M1, in welchem sich auch ein Nutzer N der Tonwiedergabeeinrichtung 1 befindet. Somit ist auch eine Membran 8 des Lautsprechers 5 beidseitig von dem ersten Medium M1 umgeben.

Um nun die Tonwiedergabeeinrichtung 1 an das Medium M1, welches beispielsweise Luft ist, an ein zweites Medium, zum Beispiel Wasser, anzupassen, wird durch die Impedanzmesseinrichtung 6 eine Messung wenigstens eines Impedanzwerts des Lautsprechers 5 ausgeführt. Das Messergebnis wird dann über ein Datenkabel K67 an die Auswerteinrichtung 7 weitergeleitet. Die Auswerteinrichtung 7 ermittelt dann auf der Basis des Messergebnisses das Medium, in welchem sich der Lautsprecher befindet. Anschließend steuert die Auswerteinrichtung 7 über ein Datenkabel K72 die Signalquelle 2 und über ein Datenkabel K73 den Verstärker 3 so an, dass Paramater wie Wiedergabelautstärke und/oder Frequenzgang derart an das detektierte Medium angepasst werden, dass für den Nutzer N unabhängig vom Medium, in welchem der Lautsprecher 5 gerade betrieben wird und in welchem sich folglich auch der Nutzer N befindet, ein gleichbleibendes Hörerlebnis sichergestellt wird. Unter einem gleichbleibenden Hörerlebnis wird im Sinne der Erfindung verstanden, dass sowohl die vom Nutzer empfundene Laustärke erhalten bleibt und als auch insbesondere das vom Nutzer empfundene Klangbild erhalten bleibt. Ziel ist es, das Hörerlebnis in beiden Medien derart aufeinander anzupassen, dass für den Nutzer ein Medienwechsel anhand der von der Tonwiedergabeeinrichtung wiedergegebenen Töne nicht erkennbar ist, um so eine Kommunikation ohne Unterbrechung zu ermöglichen.

Gemäß einer Ausführungsvariante umfasst die Tonwiedergabeeinrichtung 1 einen mit gestrichelten Linien dargestellten Tongenerator 9. Durch den Tongenerator 9 ist sind Tonsignale erzeugbar und an den Lautsprecher 5 übermittelbar. Hierdurch ist es möglich, Impedanzwerte des Lautsprechers 5 bei einzelnen Frequenzen zu messen. Der Tongenerator 9 ist in der Auswerteinrichtung 7 angeordnet und wird von dieser kontrolliert bzw. nach Bedarf aktiviert und deaktiviert.

Wie in der Figur 1 gezeigt grenzt die Membran 8 des Lautsprechers 5 der Tonwiedergabeeinrichtung 1 in dem ersten Medium M1 beidseitig an das Medium an.

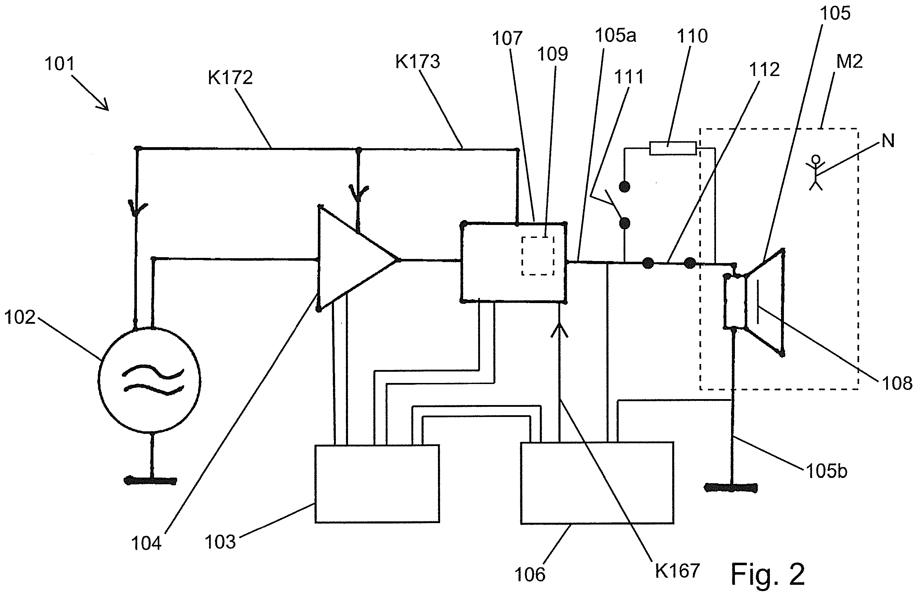

In der Figur 2 ist ein schematischer Schaltplan einer zweiten Ausführungsvariante einer erfindungsgemäßen Tonwiedergabeeinrichtung 101 gezeigt. Bezüglich des grundsätzlichen Aufbaus der Tonwiedergabeeinrichtung 101 wird auf die Beschreibung zu der in der Figur 1 gezeigten Tonwiedergabeeinrichtung verwiesen, wobei die Bezugszeichen für die in der Figur 2 gezeigten Komponenten jeweils um 100 erhöht sind. Im Unterschied zu der in der Figur 1 gezeigten Tonwiedergabeeinrichtung befindet sich der Lautsprecher 105 der in der Figur 2 gezeigten Tonwiedergabeeinrichtung 101 in einem zweiten von dem ersten Medium M1 bezüglich seiner Dichte unterschiedlichen Medium M2, welches durch Wasser gebildet ist. Die Tonwiedergabeeinrichtung 101 umfasst einen Vorwiderstand 110, wobei der Vorwiederstand 110 bei der Messung von Impedanzwerten mit der Impedanzmesseinrichtung 106 dem Lautsprecher 105 vorgeschaltet ist. Hierzu wird dann ein offen dargestellter erster Schalter 111 geschlossen und ein geschlossen dargestellter zweiter Schalter 112 geöffnet. Auch das Medium M2 umgibt die Membran 108 des Lautsprechers 105 allseitig.

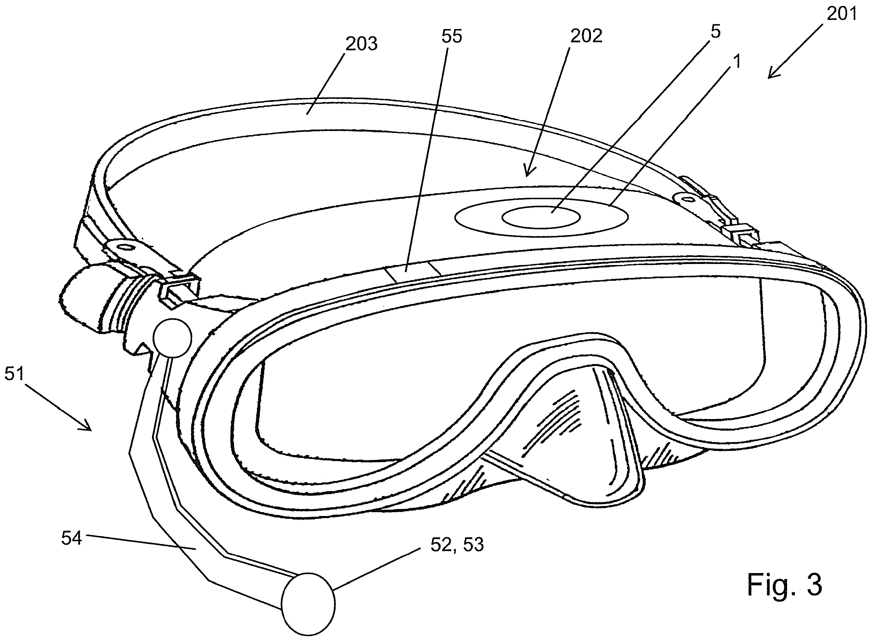

In der Figur 3 ist eine Taucherbrille 201 schematisch in perspektivischer Ansicht gezeigt. Die Taucherbrille 201 umfasst eine Tonwiedergabeeinrichtung 1 wie diese in der Figur 1 gezeigt und beschrieben ist. Hierbei ist die Tonwiedergabeeinrichtung 1 nur schematisch im Bereich einer Maske 202 der Taucherbrille 201 gezeigt, wobei der Lautsprecher 5 ebenfalls schematisch dargestellt und an der Maske 202 der Taucherbrille 201 angeordnet ist.

Die Taucherbrille 201 umfasst weiterhin eine Tonaufnahmeeinrichtung 51. Die Tonaufnahmeeinrichtung 51 ist in einem Bereich der Maske 202 angeordnet, in welchem auch ein Ende einer Brillenschlaufe 203 an der Maske 202 befestigt ist.

Diese umfasst ein Mikrofon 52, welches als Körperschallmikrofon 53 ausgebildet ist und derart an einem flexiblen Arm 54 angeordnet ist, dass dieses an einen nicht dargestellten Körper eines Nutzers angelegt werden kann.

Die Taucherbrille 201 bzw. die Tonwiedergabeeinrichtung 1 und die Tonaufnahmeeinrichtung 51 umfasst bzw. umfassen weiterhin eine Sende- und Empfangseinrichtung 55. Hierbei sind die Tonwiedergabeeinrichtung 1 und die Tonaufnahmeeinrichtung 51 an die Sende- und Empfangseinrichtung 55 angeschlossen, so dass über diese Sprachsignale drahtlos ausgesandt und empfangen werden können. Selbstverständlich sind die Tonwiedergabeeinrichtung 1 und die Tonaufnahmeeinrichtung 51 über nicht dargestellte Datenleitungen miteinander verbunden.

Die Komponenten Tonwiedergabeeinrichtung 1, Tonaufnahmeeinrichtung 51 und Sende- und Empfangseinrichtung 55 bilden unabhängig von der Taucherbrille 201 ein akustisches Kommunikationsgerät 301.

### Bezugszeichenliste:

- 1: Tonwiedergabeeinrichtung
- 2: Signalquelle
- 3: Energiequelle
- 4: Verstärker
- 5: Lautsprecher
- 5a, 5b: Lautsprecherleitung
- 6: Impedanzmesseinrichtung
- 7: Auswerteinrichtung
- 8: Membran von 5
- 9: Tongenerator

- 51: Tonaufnahmeeinrichtung
- 52: Mikrofon
- 53: Körperschallmikrofon
- 54: flexibler Arm von 51
- 55: Sende- und Empfangseinrichtung

- 101: Tonwiedergabeeinrichtung
- 102: Signalquelle
- 103: Energiequelle
- 104: Verstärker
- 105: Lautsprecher
- 105a: Lautsprecherleitung
- 105b: Lautsprecherleitung
- 106: Impedanzmesseinrichtung
- 107: Auswerteinrichtung
- 108: Membran von 5
- 109: Tongenerator
- 110: Vorwiderstand
- 111: erster Schalter
- 112: zweiter Schalter

- 201: Taucherbrille
- 202: Maske von 201
- 203: Brillenschlaufe

- 301: Kommunikationsgerät

- K67: Datenkabel zwischen 6 und 7
- K72: Datenkabel zwischen 7 und 2
- K73: Datenkabel zwischen 7 und 3

- K167: Datenkabel zwischen 106 und 107
- K172: Datenkabel zwischen 107 und 102
- K173: Datenkabel zwischen 107 und 103

- M1: erstes Medium, Luft
- M2: zweites Medium, Wasser
- N: Nutzer

## Patentansprüche

1. Tonwiedergabeeinrichtung (1; 101), welche eine Signalquelle (2; 102), eine Energiequelle (3; 103), einen Verstärker (4; 104) und einen Lautsprecher (5; 105) umfasst,
- wobei die Tonwiedergabeeinrichtung (1; 101) weiterhin eine Impedanzmesseinrichtung (6; 106) und eine Auswerteinrichtung (7; 107) umfasst,
- wobei die Impedanzmesseinrichtung (6; 106) zur Messung von Impedanzwerten an Lautsprecherleitungen (5a, 5b; 105a, 105b) des Lautsprechers (5; 105) angeschlossen ist,
- wobei die Impedanzmesseinrichtung (6; 106) zur Weiterleitung von Messergebnissen an die Auswerteinrichtung (7; 107) angeschlossen ist,
- wobei die Auswerteinrichtung (7; 107) zur Anpassung eines dem Lautsprecher (5; 105) zugeführten Signals an die Signalquelle (2; 102) und/oder an den Verstärker (4; 104) angeschlossen ist,
**dadurch gekennzeichnet dass**
- eine Membran (8; 108) des Lautsprechers (5; 105) der Tonwiedergabeeinrichtung (1; 101) unter Wasser beidseitig an das Medium (M2) Wasser angrenzt und über Wasser beidseitig an das Medium (M1) Luft angrenzt,
- dass die Auswerteinrichtung (7; 107) weiterhin so angeordnet ist, aus dem Messergebnis das Medium (M1; M2), in welchem sich der Lautsprecher (5; 105) befindet, zu ermitteln,
- dass die Signalquelle (2; 102) und/oder der Verstärker (4; 104) von der Auswerteinrichtung (7; 107) derart angesteuert wird, dass Paramater Wiedergabelautstärke **und/oder** Frequenzgang derart an das detektierte Medium (M1; M2) angepasst werden, dass für einen Nutzer (N) unabhängig von dem Medium (M1; M2), in welchem der Lautsprecher (5; 105) betrieben wird, ein gleichbleibendes Hörerlebnis sichergestellt wird.

2. Tonwiedergabeeinrichtung nach Anspruch 1, **dadurch gekennzeichnet, dass** die Tonwiedergabeeinrichtung (101) einen Vorwiderstand (110) umfasst, wobei der Vorwiderstand (110) bei der Messung von Impedanzwerten mit der Impedanzmesseinrichtung (106) dem Lautsprecher (105) vorgeschaltet ist.

3. Tonwiedergabeeinrichtung nach Anspruch 1 oder 2, **dadurch gekennzeichnet, dass** die Tonwiedergabeeinrichtung (1; 101) einen Tongenerator (9; 109) umfasst, wobei durch den Tongenerator (9; 109) Tonsignale erzeugbar und an den Lautsprecher (5; 105) übermittelbar ist.

4. Tonwiedergabeeinrichtung nach Anspruch 3, **dadurch gekennzeichnet, dass** der Tongenerator (9; 109) von der Auswerteinrichtung (7; 107) oder der Impedanzmesseinrichtung (6; 106) kontrolliert ist.

5. Verfahren zur Anpassung einer Tonwiedergabeeinrichtung (1; 101) entsprechend einem der vorhergehenden Ansprüche, **dadurch gekennzeichnet, dass** von der Impedanzmesseinrichtung (6; 106) kontinuierlich Impedanzwerte gemessen werden oder dass von der Impedanzmesseinrichtung (6; 106) in Intervallen Impedanzwerte gemessen werden oder dass von der Impedanzmesseinrichtung (6; 106) Impedanzwerte ereignisgesteuert gemessen werden.

6. Verfahren nach Anspruch 5, **dadurch gekennzeichnet, dass** die Messung von Impedanzwerten durch die Impedanzmesseinrichtung (6; 106) im Bereich einer Resonanz des Lautsprechers (5; 105) erfolgt.

7. Verfahren nach Anspruch 5 oder 6, **dadurch gekennzeichnet, dass** von einem Tongenerator (9; 109) der Tonwiedergabeeinrichtung (1; 101) ein Testsignal erzeugt wird und an den Lautsprecher (5; 105) übermittelt wird und dass gleichzeitig eine Messung von Impedanzwerten mit der Impedanzmesseinrichtung (6; 106) durchgeführt wird.

8. Verfahren nach Anspruch 7, **dadurch gekennzeichnet, dass** das Testsignal insbesondere kurzzeitig und in einer Kommunikationspause erzeugt wird.

9. Verfahren nach Anspruch 7 oder 8, **dadurch gekennzeichnet, dass** das Testsignal in einem vom Nutzer (N) nicht wahrnehmbaren Frequenzbereich erzeugt wird.

10. Taucherbrille (201), **dadurch gekennzeichnet, dass** die Tauscherbrille (201) eine Tonwiedergabeeinrichtung (1; 101) entsprechend wenigstens einem der Ansprüche 1 bis 4 umfasst.

11. Taucherbrille nach Anspruch 10, **dadurch gekennzeichnet, dass** der Lautsprecher (5; 105) der Tonwiedergabeeinrichtung (1; 101) an einer Maske (202) der Taucherbrille (201) angeordnet ist oder dass der Lautsprecher (5; 105) der Tonwiedergabeeinrichtung (1; 101) an einer Brillenschlaufe (203) der Taucherbrille (201) angeordnet ist.

12. Taucherbrille nach Anspruch 10 oder 11, **dadurch gekennzeichnet, dass** die Taucherbrille (201) eine Tonaufnahmeeinrichtung (51) umfasst, wobei die Tonaufnahmeeinrichtung (51) wenigstens ein Mikrofon (52) umfasst, welches insbesondere als Körperschallmikrofon (53) ausgebildet ist und dass die Taucherbrille (201) eine Sende- und Empfangseinrichtung (55) umfasst, wobei die Tonwiedergabeeinrichtung (1; 101) und die Tonaufnahmeeinrichtung (51) an die Sende- und Empfangseinrichtung (55) angeschlossen sind.

13. Kommunikationsgerät (301), **dadurch gekennzeichnet, dass** das Kommunikationsgerät (301) eine Tonwiedergabeeinrichtung (1; 101) nach wenigstens einem der Ansprüche 1 bis 4 umfasst und dass das Kommunikationsgerät (301) eine Tonaufnahmeeinrichtung (51) umfasst, wobei die Tonaufnahmeeinrichtung (51) wenigstens ein Mikrofon (52) umfasst, welches insbesondere als Körperschallmikrofon (53) ausgebildet ist und dass das Kommunikationsgerät (301) eine Sende- und Empfangseinrichtung (55) umfasst, wobei die Tonwiedergabeeinrichtung (1; 101) und die Tonaufnahmeeinrichtung (51) an die Sende- und Empfangseinrichtung (55) angeschlossen sind.

## Claims

1. Sound reproduction device (1; 101) comprising a signal source (2; 102), a power source (3; 103), an amplifier (4; 104) and a loudspeaker (5; 105),
- wherein the sound reproduction device (1; 101) also comprises an impedance measuring device (6, 106) and an analysis device (7; 107),
- wherein the impedance measuring device (6; 106) is connected to loudspeaker leads (5a, 5b; 105a, 105b) of the loudspeaker (5; 105) in order to measure impedance values,
- wherein the impedance measuring device (6; 106) is connected to the analysis device (7; 107) in order to forward measurement results,
- wherein the analysis device (7; 107) is connected to the signal source (2; 102) and/or to the amplifier (4; 104) in order to adapt a signal fed to the loudspeaker (5; 105), **characterized in that**
- a diaphragm (8; 108) of the loudspeaker (5; 105) of the sound reproduction device (1; 101) is adjacent on both sides to the medium (M2) water when under water and is adjacent on both sides to the medium (M1) air when above water,
- **in that** the analysis device (7; 107) is also designed to use the measurement result to determine the medium (M1; M2) in which the loudspeaker (5; 105) is located,
- **in that** the signal source (2; 102) and/or the amplifier (4; 104) are/is driven by the analysis device (7; 107) in such a manner that the parameters reproduction volume and/or frequency response are adapted for the detected medium (M1; M2) in such a way that a consistent listening experience is ensured for a user (N) regardless of the medium (M1; M2) in which the loudspeaker (5; 105) is operated.

2. Sound reproduction device according to Claim 1, **characterized in that** the sound reproduction device (101) comprises a series resistance (110), wherein the series resistance (110) is connected upstream of the loudspeaker (105) when measuring impedance values using the impedance measuring device (106).

3. Sound reproduction device according to Claim 1 or 2, **characterized in that** the sound reproduction device (1; 101) comprises a tone generator (9; 109), wherein sound signals can be generated by the tone generator (9; 109) and transmitted to the loudspeaker (5; 105).

4. Sound reproduction device according to Claim 3, **characterized in that** the tone generator (9; 109) is controlled by the analysis device (7; 107) or the impedance measuring device (6, 106).

5. Method for adapting a sound reproduction device (1; 101) in accordance with one of the preceding claims, **characterized in that** impedance values are measured by the impedance measuring device (6; 106) continuously or **in that** impedance values are measured by the impedance measuring device (6; 106) at intervals or **in that** impedance values are measured by the impedance measuring device (6; 106) in an event-driven manner.

6. Method according to Claim 5, **characterized in that** the measurement of impedance values by the impedance measuring device (6; 106) is performed in the region of a resonance of the loudspeaker (5; 105).

7. Method according to Claim 5 or 6, **characterized in that** a test signal is generated by a tone generator (9; 109) of the sound reproduction device (1; 101) and transmitted to the loudspeaker (5; 105) and **in that** at the same time a measurement of impedance values is carried out using the impedance measuring device (6; 106) .

8. Method according to Claim 7, **characterized in that** the test signal is generated in particular for a short period of time and during a communication pause.

9. Method according to Claim 7 or 8, **characterized in that** the test signal is generated in a frequency range that is not perceptible to the user (N).

10. Diving goggles (201), **characterized in that** the diving goggles (201) comprise a sound reproduction device (1; 101) in accordance with at least one of Claims 1 to 4.

11. Diving goggles according to Claim 10, **characterized in that** the loudspeaker (5; 105) of the sound reproduction device (1; 101) is arranged on a mask (202) of the diving goggles (201) or **in that** the loudspeaker (5; 105) of the sound reproduction device (1; 101) is arranged on a goggles strap (203) of the diving goggles (201) .

12. Diving goggles according to Claim 10 or 11, **characterized in that** the diving goggles (201) comprise a sound recording device (51), wherein the sound recording device (51) comprises at least one microphone (52), which is in particular in the form of a contact microphone (53), and **in that** the diving goggles (201) comprise a transmitting and receiving device (55), wherein the sound reproduction device (1; 101) and the sound recording device (51) are connected to the transmitting and receiving device (55).

13. Communication device (301), **characterized in that** the communication device (301) comprises a sound reproduction device (1; 101) according to at least one of Claims 1 to 4 and **in that** the communication device (301) comprises a sound recording device (51), wherein the sound recording device (51) comprises at least one microphone (52), which is in particular in the form of a contact microphone (53), and **in that** the communication device (301) comprises a transmitting and receiving device (55), wherein the sound reproduction device (1; 101) and the sound recording device (51) are connected to the transmitting and receiving device (55).

## Revendications

1. Dispositif de reproduction sonore (1 ; 101), lequel comprend une source de signal (2 ; 102), une source d'énergie (3 ; 103), un amplificateur (4 ; 104) et un haut-parleur (5 ; 105),
- le dispositif de reproduction sonore (1 ; 101) comprenant en outre un dispositif de mesure d'impédance (6 ; 106) et un dispositif d'évaluation (7 ; 107),
- le dispositif de mesure d'impédance (6 ; 106) étant raccordé à des lignes de haut-parleur (5a, 5b ; 105a, 105b) du haut-parleur (5 ; 105) pour la mesure de valeurs d'impédance,
- le dispositif de mesure d'impédance (6 ; 106) étant raccordé au dispositif d'évaluation (7 ; 107) pour la transmission des résultats de mesure,
- le dispositif d'évaluation (7 ; 107) étant raccordé à la source de signal (2 ; 102) et/ou à l'amplificateur (4 ; 104) en vue d'adapter un signal acheminé au haut-parleur (5 ; 105), **caractérisé en ce que**
- une membrane (8 ; 108) du haut-parleur (5 ; 105) du dispositif de reproduction sonore (1 ; 101) est adjacente des deux côtés au milieu (M2) eau sous l'eau et est adjacente des deux côtés au milieu (M1) air au-dessus de l'eau,
- le dispositif d'évaluation (7 ; 107) est en outre disposé de manière à déterminer, à partir du résultat de mesure, le milieu (M1 ; M2) dans lequel se trouve le haut-parleur (5 ; 105),
- la source de signal (2 ; 102) et/ou l'amplificateur (4 ; 104) est commandé par le dispositif d'évaluation (7 ; 107) de telle sorte que les paramètres de volume de reproduction et/ou de réponse en fréquence sont adaptés au milieu (M1 ; M2) détecté de sorte qu'une expérience d'écoute constante est garantie pour un utilisateur (N) indépendamment du milieu (M1 ; M2) dans lequel fonctionne le haut-parleur (5 ; 105).

2. Dispositif de reproduction sonore selon la revendication 1, **caractérisé en ce que** le dispositif de reproduction sonore (101) comprend une résistance en série (110), la résistance en série (110) étant branchée en amont du haut-parleur (105) lors de la mesure de valeurs d'impédance avec le dispositif de mesure d'impédance (106).

3. Dispositif de reproduction sonore selon la revendication 1 ou 2, **caractérisé en ce que** le dispositif de reproduction sonore (1 ; 101) comporte un générateur de sons (9 ; 109), des signaux sonores pouvant être générés et communiqués au haut-parleur (5 ; 105) par le générateur de sons (9 ; 109).

4. Dispositif de reproduction sonore selon la revendication 3, **caractérisé en ce que** le générateur de son (9 ; 109) est contrôlé par le dispositif d'évaluation (7 ; 107) ou le dispositif de mesure d'impédance (6 ; 106) .

5. Procédé d'adaptation d'un dispositif de reproduction sonore (1 ; 101) selon l'une des revendications précédentes, **caractérisé en ce que** des valeurs d'impédance sont mesurées en continu par le dispositif de mesure d'impédance (6 ; 106), ou **en ce que** des valeurs d'impédance sont mesurées à des intervalles donnés par le dispositif de mesure d'impédance (6 ; 106), ou **en ce que** des valeurs d'impédance sont mesurées sur commande d'un événement par le dispositif de mesure d'impédance (6 ; 106).

6. Procédé selon la revendication 5, **caractérisé en ce que** la mesure de valeurs d'impédance par le dispositif de mesure d'impédance (6 ; 106) est effectuée dans la plage d'une résonance du haut-parleur (5 ; 105).

7. Procédé selon la revendication 5 ou 6, **caractérisé en ce qu'**un signal de test est généré par un générateur de son (9 ; 109) du dispositif de reproduction sonore (1 ; 101) et est communiqué au haut-parleur (5 ; 105), et **en ce qu'**une mesure de valeurs d'impédance est effectuée simultanément avec le dispositif de mesure d'impédance (6 ; 106).

8. Procédé selon la revendication 7, **caractérisé en ce que** le signal de test est notamment généré pendant une courte durée et dans une pause de communication.

9. Procédé selon la revendication 7 ou 8, **caractérisé en ce que** le signal de test est généré dans une plage de fréquences non perceptible par l'utilisateur (N).

10. Masque de plongée (201), **caractérisé en ce que** le masque de plongée (201) comprend un dispositif de reproduction sonore (1 ; 101) selon au moins l'une des revendications 1 à 4.

11. Masque de plongée selon la revendication 10, **caractérisé en ce que** le haut-parleur (5 ; 105) du dispositif de reproduction sonore (1 ; 101) est disposé au niveau d'un masque (202) du masque de plongée (201) ou **en ce que** le haut-parleur (5 ; 105) du dispositif de reproduction sonore (1 ; 101) est disposé sur une sangle de masque (203) du masque de plongée (201).

12. Masque de plongée selon la revendication 10 ou 11, **caractérisé en ce que** le masque de plongée (201) comprend un dispositif d'enregistrement de son (51), le dispositif d'enregistrement de son (51) comprenant au moins un microphone (52), lequel est notamment réalisé sous la forme d'un microphone à bruits de structure (53), et **en ce que** le masque de plongée (201) comporte un dispositif d'émission et de réception (55), le dispositif de reproduction sonore (1 ; 101) et le dispositif d'enregistrement de son (51) étant raccordés au dispositif d'émission et de réception (55).

13. Appareil de communication (301), **caractérisé en ce que** l'appareil de communication (301) comporte un dispositif de reproduction sonore (1 ; 101) selon au moins l'une des revendications 1 à 4 et **en ce que** l'appareil de communication (301) comporte un dispositif d'enregistrement de son (51), le dispositif d'enregistrement de son (51) comprenant au moins un microphone (52), lequel est notamment réalisé sous la forme d'un microphone à bruits de structure (53), et **en ce que** l'appareil de communication (301) comporte un dispositif d'émission et de réception (55), le dispositif de reproduction sonore (1 ; 101) et le dispositif d'enregistrement sonore (51) étant raccordés au dispositif d'émission et de réception (55).
